(19) Europäisches Patentamt / European Patent Office / Office européen des brevets

(11) **EP 3 919 740 B1**

(12) **EUROPEAN PATENT SPECIFICATION**

(45) Date of publication and mention
of the grant of the patent:
**11.01.2023 Bulletin 2023/02**

(21) Application number: **20178328.9**

(22) Date of filing: **04.06.2020**

(51) International Patent Classification (IPC):
**F03D 17/00** *(2016.01)*     **F03D 80/30** *(2016.01)*
**F03D 80/40** *(2016.01)*     **G01R 27/08** *(2006.01)*

(52) Cooperative Patent Classification (CPC):
**F03D 17/00; F03D 80/30; F03D 80/40; G01R 27/08;**
F05B 2260/83; Y02E 10/72

(54) **METHOD OF MONITORING AND CONTROLLING A CONDITION OF A WIND TURBINE ROTOR BLADE, WIND TURBINE AND COMPUTER READABLE STORAGE MEDIUM**

VERFAHREN ZUR ÜBERWACHUNG UND STEUERUNG EINES ZUSTANDES EINES WINDTURBINENROTORBLATTES, WINDTURBINE UND COMPUTERLESBARES SPEICHERMEDIUM

PROCÉDÉ DE SURVEILLANCE ET DE CONTRÔLE DE L'ÉTAT D'UNE PALE DE ROTOR D'ÉOLIENNE, ÉOLIENNE ET SUPPORT D'ENREGISTREMENT LISIBLE PAR ORDINATEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**08.12.2021 Bulletin 2021/49**

(73) Proprietor: **Nordex Energy SE & Co. KG**
**22419 Hamburg (DE)**

(72) Inventor: **Previtali, Francesco**
**22525 Hamburg (DE)**

(74) Representative: **Epping - Hermann - Fischer**
**Patentanwaltsgesellschaft mbH**
**Schloßschmidstraße 5**
**80639 München (DE)**

(56) References cited:
**EP-A1- 2 420 852     WO-A1-2017/167347**
**CN-B- 106 168 640     DE-A1-102013 217 129**

EP 3 919 740 B1

## Description

Wind turbines are used to convert wind energy into electrical energy. For this purpose they conventionally have one rotor blade (wind turbine rotor blade) or several rotor blades.

Due to a variety of external conditions, e.g. lightning strikes, bird strikes, fatigue during operation, rotor blades degrade over time and may suffer failures. In particular, electrical components, e.g. made of metallic material, may degrade and may compromise a functionality of the blades.

For example, rotor blades can ice up under certain environmental conditions. Icing of the rotor blades can, for example, lead to a deterioration of the aerodynamic properties or have other negative effects on the operation of the wind turbine. Therefore, rotor blades in cold climate regions are often equipped with anti-icing systems. These can be constituted e.g. by one or more electrical heating elements, which are arranged on the outer surface of the rotor blades, especially directly below the outer skin, and are intended to counteract icing of the rotor blades at least in the area of the profile nose edge. EP 3 165 761 A1 and EP 2 843 228 A1 are given as examples. However, these heating systems may deteriorate over time or even fail, leading to an accumulation of ice on the surface of the rotor blade. This can lead to an unbalance of the rotor blade and to significant damages to the wind turbine. A prior art example is disclosed in WO2017/167347A1.

It is desirable to specify a concept for a wind turbine rotor blade which contributes to a reliable operation of the rotor blade and/or the wind turbine.

According to an aspect of the invention, a method of monitoring and controlling a condition of a wind turbine rotor blade of a wind turbine is disclosed. The method comprises the steps of:

- performing a first measurement comprising the sub-steps of:

  - measuring a first value of voltage applied to a conductive device of the wind turbine rotor blade; and
  - measuring a first value of current flowing through the conductive device, the first value of current corresponding to the first value of voltage;

- calculating a first resistance value of the conductive device depending on the measured first value of voltage and the measured first value of current;
- performing a second measurement comprising the sub-steps of:

  - measuring a second value of voltage applied to the conductive device, the second value of voltage being higher or lower than the first value of voltage;

  - measuring a second value of current flowing through the conductive device, the second value of current corresponding to the first value of voltage and the second value of current being different than the first value of current;

- calculating a second resistance value of the conductive device depending on the measured second value of voltage and the measured second value of current; and
- comparing the first resistance value and the second resistance value in order to determine the condition of the wind turbine rotor blade.

It is realized that components of a wind turbine rotor blade, which are made of metallic materials, often degrade mechanical properties faster than other parts of the rotor blade, which are made of other materials, e.g. composite materials. In particular, the degradation of material of electric components (conductors in general, heating elements, lightning conductors and others) results in an increase of the electric resistance of these components. This might compromise the functionality of the electric components and even of the turbine blade. It has been realized that, if such materials are subjected to cyclic loads, the electrical resistance of these elements increase over the time. During a test campaign it was observed that there is an additional correlation between the resistance and the current/voltage intensity used for the measurements such that the resistance decreases at higher current/voltage.

For example, micro-cracks in these conductive materials, which locally reduce the cross-section of these conductive materials, have an impact to the measured resistance values. The inventor discovered that higher voltages/currents are able to bridge failures/degradations like these micro-cracks, whereas lower voltages/currents cannot bridge these failures/degradations. Generally spoken, the higher the voltage/current, the bigger the defect size that can be bridged.

The Ohm's law states that the electric resistance is independent from the applied current. This apply to all ohmic materials, which include conventional metallic materials. It was observed that degraded or damaged components display a non-ohmic behaviour. The higher the degradation, the more the material display a non-ohmic behaviour.

According to the inventive method the resistance of a conductive device (conductive component) of the wind turbine rotor blade is determined using different values of current/voltage. In particular, a first value of voltage and a first value of current are measured and subsequently a second value of voltage and a second value of current are measured. In particular, the second value of voltage and second value of current are higher or lower than the first value of voltage and the first value of current (e.g. 200V vs. 400V). Depending on the first and second measurements two resistance values are calculated, which resistance values can be compared for the same conductive component in order to determine a condition of the wind turbine rotor blade or the conductive component respectively. If the conductive component has not suffered any degradation, the comparison of both resistance values should show no, or only very little, difference. In other words, the resistance values should be the same or nearly the same, bearing Ohm's Law in mind. However, if the wind turbine rotor blade, and in particular the conductive component, has suffered (mechanical) degradations/failures, the resistance values as calculated above will be different from each other. This means for example that the second resistance value for a higher current will be lower than the first resistance value for a lower current, thereby indicating a degree of wear, degradation or any other failure due to the mentioned variety of external conditions.

The disclosed method offers an inexpensive solution for monitoring the health of a conductive, electronic device.

Furthermore, the suggested method even allows conclusions to be drawn about the overall mechanical condition of the wind turbine rotor blade. This allows to use the method as part of the rotor blade health monitoring system. For example, due to results of the inventive method, one can decide whether and when to inspect the wind turbine, its blades or its electrical systems. Thus it is possible to reduce the amount of service intervals necessary for inspecting the wind turbine.

In embodiments, the measurements can be repeated for different values of voltage/current to increase the reliability of the method. In particular, further measurements can be performed for further (higher or lower) values of current or voltage, being different to the values of the first and second measurements.

Here and in the following the conductive device is an electrically conductive device, an electric system or an electric arrangement forming a circuit. Such device may comprise one or more electrical components, which are electrically interconnected, directly and/or indirectly, in order to be used for the claimed method. For example, such a conductive device may be a heating system, a lightning protection system or the like.

The steps of the described method may be changed partially. For example, the steps of calculating the first and second resistance value may be performed after having performed both first and second measurements.

For example, the method is performed with the help of an appropriate electrical system for measuring the values of current and the values of voltage, e.g. an electrical test or measurement system/device. It is clear to a person skilled in the art that such system comprises a kind of energy source and needs to apply voltages and/or currents to the conductive device. This means that respective voltages or a currents are applied to the electric device in order to perform the measurements for obtaining the first and second voltages/currents. Such a system is accordingly connected to the respective conductive device in order to have an electronic circuit, which allows the voltages and the currents to be measured. The voltages may be measured by a voltmeter. The currents may be measured by an ammeter. Such electrical test system is typically connected to the conductive device in the root area of the wind turbine blade.

To sum up, for one respective conductive device with the same setup two or more measurements are performed at different values for the voltage/current in order to receive at least two resistance values to be compared to each other.

According to an embodiment, the step of comparing comprises determining a difference between the first resistance value and the second resistance value, wherein based on the determined difference the condition of the wind turbine blade is determined. For example, the determined difference corresponds to a failure or a degradation of the wind turbine blade, in particular an electrical or mechanical degradation or an electrical or mechanical failure. For example, a degradation of the electrically conductive device, e.g. electrical components like electrical conductors, lines and the like is determined. These failures or degradations may arise due to dynamic or static loads, mechanical fatigue and/or thermal fatigue, exposure to the environment such as to sun, wind, sleet, snow and the like. The difference may be compared to a threshold value of resistance, indicating a critical degradation or failure.

According to an embodiment, based on the determined condition, a service center, which is located remotely from the wind turbine, is provided with information. For example, the method may provide messages or signals to a service center, also called "control center", for example through a turbine control system. The service center is at a distance to the wind turbine or the blade. Thus, the disclosed method can be used to track the failure or degradation of the wind turbine blade and may inform the service center. For example, in the case that during comparison of the resistance values a critical threshold is exceeded, the service center is informed.

In an embodiment, the conductive device is a lightning protection system comprising two electrical main conductors. The two electrical main conductors essentially extend from a root area of the wind turbine blade towards a tip area of the wind turbine blade. The two electrical main conductors are electrically interconnected. By the electrical interconnection of the two main conductors, the main conductors form the electrically conductive device to be analysed as described above. Thus, the method can determine the condition of the lightning protection system.

In an embodiment the two electrical main conductors of the lightning protection system are interconnected in the tip area of the wind turbine blade. This ensures that most of the lightning protection system can be analysed via the described method.

In an embodiment the electrically conductive device is a heating system, the heating system comprising two electrical main conductors and at least one resistive heating element. The two main conductors essentially extend from a root area of the wind turbine blade towards a tip area of the wind turbine blade and the at least one heating element is electrically connected to both of the two main conductors in order to be supplied with heating current. Thus, it is possible to determine a condition of the heating system of the wind turbine blade.

In an embodiment the heating system comprises several resistive heating elements, each heating element being electrically connected to both of the two main conductors in order to be supplied with heating current. The steps of performing the first and second measurement are performed on one of the heating elements or a group of heating elements. For example, the electric test system is accordingly attached to one heating element or a group of heating elements. Thus, a single heating element or a group of heating elements can be analysed with the method described above.

In an embodiment, wherein the step of performing the first measurement and the step of performing the second measurement is done within a time range of 1 hour, preferably of 30 minutes, 10 minutes, 5 minutes or less. Alternatively, the two measurements are performed within a time range of one or more, e.g. 2, 5 or 100, rotor revolutions. Most preferable, the steps of performing the first measurement and performing the second measurement are executed immediately after one another. These embodiments ensure that both measurements are performed under nearly the same external conditions. Thus, environmental influences, e.g. sun, temperature, wind, rain and the like, are the same for both measurements. Thus, the calculated resistance values and the comparison of both resistance values is very reliable compared to measurements performed on different days or even hours after one another. Thus, it is avoided to get wrong results, if, for example, the first measurement would be performed on a first day and the second measurement would be performed on a second day, wherein the weather conditions during the measurements change. Thus, the method as described above accounts for different temperatures and other environmental and operational conditions and ensures a very reliable result when comparing the resistance values.

In an embodiment, the method is repeated at regular intervals. For example, the method is performed each day or every 12 hours or at other regular intervals. Thus, the method provides reliable results about the condition of the wind turbine blade or the conductive device respectively over long periods.

In an embodiment, depending on the determined condition of the wind turbine blade, the wind turbine or the wind turbine rotor blade is adjusted. For example, adjusting means to pitch one or several wind turbine rotor blades and/or to yaw the nacelle of the wind turbine in order to take into account the condition of the wind turbine rotor blade or rotor blades. For example, the adjustment can ensure that the loads acting on the wind turbine rotor blades are reduced by rotating (pitching) the rotor blades along their own longitudinal axis in order that forces acting on the blades are reduced. This means that, although the output generated by the wind turbine is probably less than it could be at that moment, the lifetime of the wind turbine and its components could be increased. Thus it is possible to reduce the amount of service intervals necessary for inspecting the wind turbine.

According to another aspect, a wind turbine is disclosed. The wind turbine comprises a rotor with one or more wind turbine rotor blades and a data processing device. The data processing device has a processor and a memory, the memory storing program code for performing a method according to the aspect described above, wherein the program code is executed by the processor.

In another aspect a computer readable storage medium is disclosed, the storage medium having instructions stored thereon of a method according to the first aspect to be executed by a processor.

The wind turbine and the computer readable storage medium essentially enable the mentioned technical effects, functions and advantages. The above-mentioned embodiments similarly apply to the wind turbine and the computer readable storage medium.

Further advantageous embodiments are disclosed in the following detailed description of exemplary embodiments. The embodiments will hereinafter be described with reference to the attached figures. Elements of the same type or with the same effect are provided with the same reference signs for all figures.

The figures show in:

Figure 1 a schematic diagram of a wind turbine according to an example,

Figure 2 a schematic perspective view of a wind turbine rotor blade,

Figure 3 a schematic diagram showing two graphs with resistances plotted as a function of applied currents,

Figure 4 a schematic view of a heating system of a wind turbine rotor blade,

Figure 5 a schematic example of a wind turbine rotor blade with the heating system of figure 4,

Figure 6 a schematic flowchart of a method for monitoring and controlling a condition of a wind turbine rotor blade of a wind turbine according to an example of the invention,

Figure 7 a schematic 3D-diagramm showing resistances depending on current and time, and

Figure 8 a further example of a wind turbine rotor blade with a lightning protection system.

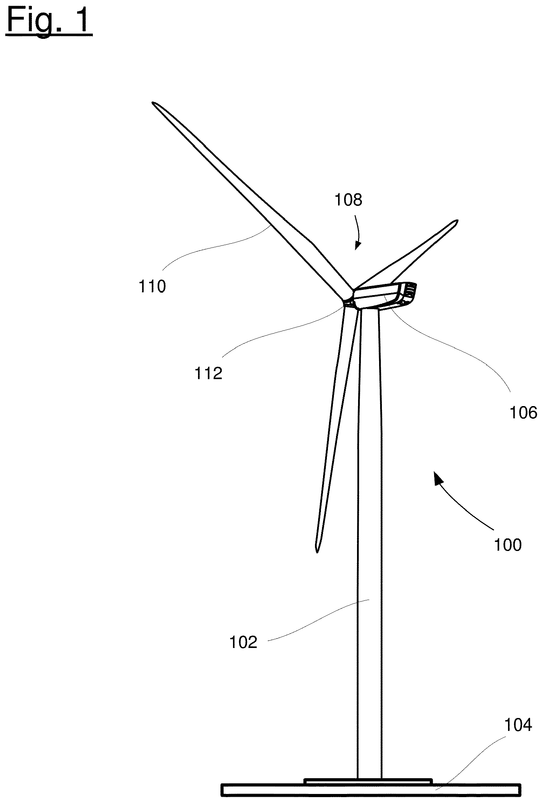

Figure 1 shows a schematic diagram of a wind turbine 100, which has a tower 102. The tower 102 is fixed to a foundation 104 on a subsoil. At one end of tower 102, which is opposite the foundation, a nacelle 106 is rotatably mounted. The nacelle 106, for example, has a generator that is coupled to a rotor 108 via a rotor shaft (not shown). The rotor 108 has one or more wind turbine rotor blades 110, which are arranged on a rotor hub 112.

During operation, the rotor 108 is set in rotation by an air flow, in particular wind. This rotational movement is transmitted to the generator via the rotor shaft and, if necessary, a gearbox. The generator converts the kinetic energy of the rotor 108 into electrical energy.

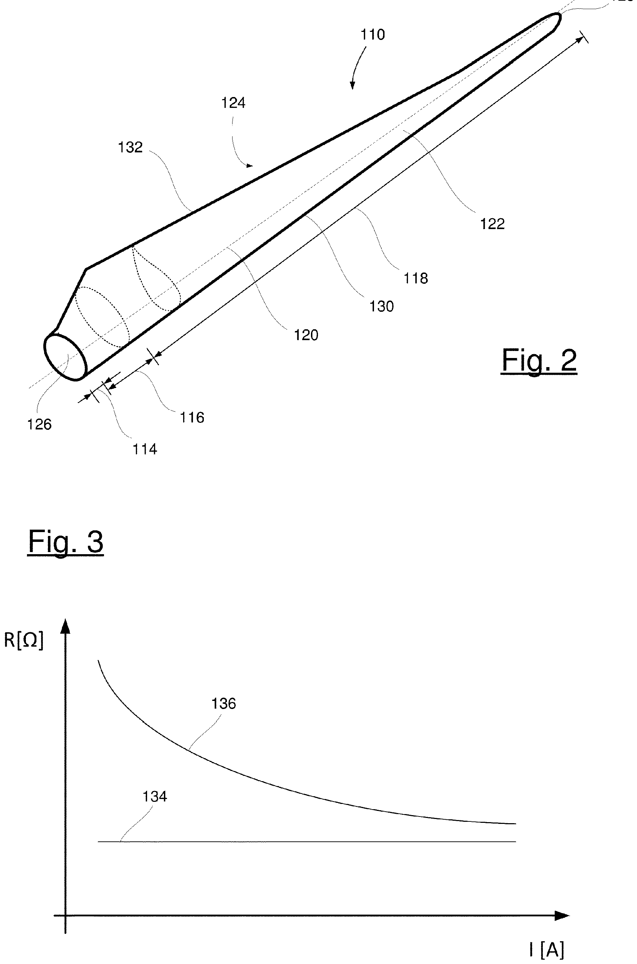

Figure 2 shows an exemplary wind turbine rotor blade 110. The wind turbine rotor blade 110 has the shape of a conventional rotor blade and has a rotor blade root area 114 facing the rotor hub 112. The rotor blade root area 114 typically has an essentially circular cross-section. The rotor blade root area 114 is followed by a transition area 116 and by a profile area 118 of the rotor blade 110. The rotor blade 110 has a longitudinal axis 120 as well as a pressure side 122 and an opposite suction side 124. The rotor blade 110 is essentially hollow inside. The rotor blade 110 has a blade root end 126 and a blade tip end 128. The rotor blade 110 has a profile leading edge 130 and a profile trailing edge 132.

Figure 3 shows a diagram having two curves 134 and 136, which represent a function of a resistance depending on a current.

The first curve 134 represents a linear (ohmic) dependency of the current and the resistance according to Ohm's Law,

$$R = \frac{V}{I}$$

where R represents the resistance, V represents the voltage and I represents the current. The current through an electronic conductive device is inversely related to the resistance of this device because as the voltage applied to this device remains the same, a decrease in resistance of the device will increase the current through this device. On the other hand, the voltage applied to this device is directly related to the current, because as the resistance through this device remains the same, an increase in the voltage applied to the device will increase the current of the device.

The second curve 136 shows a non-linear (non-ohmic) dependency of the current and the resistance R, wherein the electrically conductive device of a wind turbine rotor blade has undergone degradation due to fatigue testing. The resistance R decreases as a function of the applied current. In other words, the higher the current (or voltage) applied to the conductive device, the further the resistance decreases.

Thus, from Figure 3 it can be exemplarily derived that an evaluation of resistances of electronic components at different values of voltage/current can provide information on whether degradation or failure of electrical components as well as the mechanical properties of the wind turbine rotor blade has occurred.

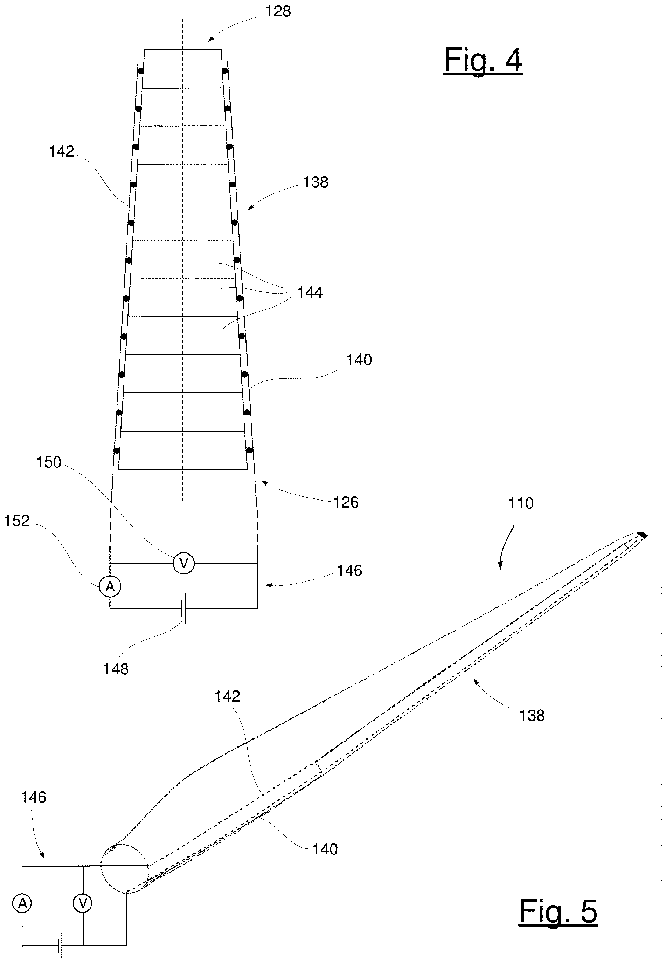

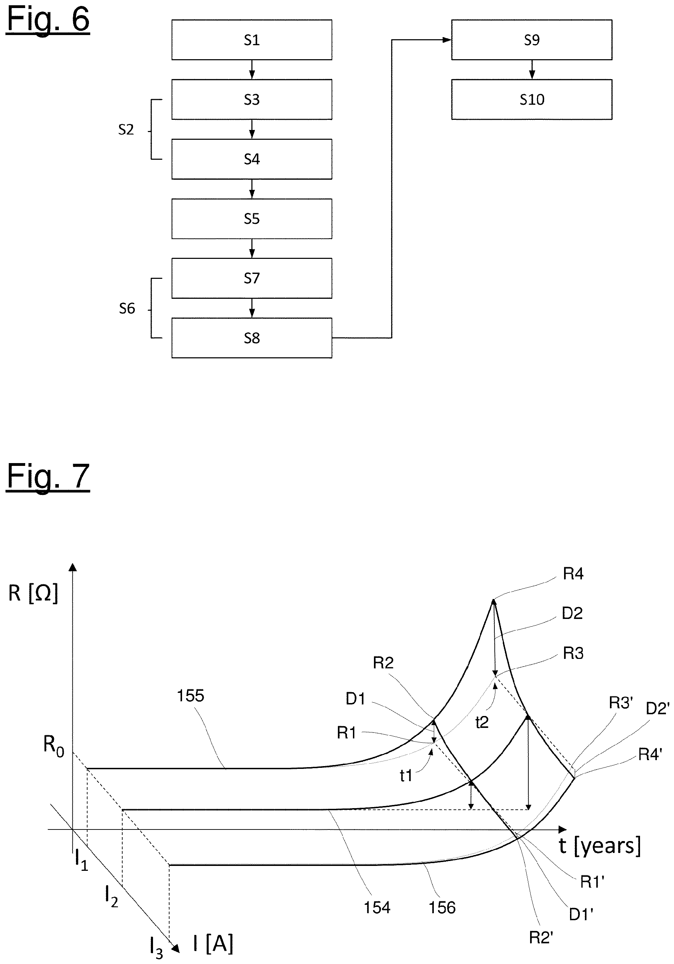

In the following, a method for controlling and monitoring a condition of a wind turbine rotor blade 110 based on resistances will be described with the help of an exemplary wind turbine rotor blade 110 according to Figures 4 and 5 and a flowchart according to Figure 6.

Figure 4 shows a heating system 138 for a wind turbine rotor blade 110, e.g. the blade 110 of a wind turbine 100 according to Figures 1 and 2. Figure 5 shows the exemplary wind turbine rotor blade 110, which has the heating system 138 representing an electrically conductive device.

The heating system 138 comprises two main conductors 140 and 142 (main electrical lines), which extend from the blade root end 126 towards the blade tip end 128. Several resistive heating elements 144 of the heating system 138 each are interconnected in parallel to the two main conductors 140 and 142, such that they can be supplied with heating current over the main conductors 140, 142.

For applying the method for controlling and monitoring a condition of the wind turbine rotor blade 110, an electric measuring system 146 is connected to the heating system 138, e.g. to the main conductors 140, 142 in an area at the root end 126. The electric measuring system 146 comprises for example an energy source 148, a voltage measuring device 150 (e.g. a voltmeter) and a current measuring device 152 (e.g. an ammeter).

In a first step S1 of the method the heating system 138 is supplied with a predetermined power, such that a current is flowing through the heating system 138 at a certain voltage.

In a next step S2, a first measurement is performed on the heating system 138. This first measurement comprises the sub-steps S3 and S4, wherein in the step S3 a first value of a voltage applied to the heating system 138 is measured. In the step S4 a first value of a current is measured, which corresponds to the first value of a voltage.

In a next step S5, a first resistance value of the heating system 138 is calculated depending on the measured first value of voltage at the measured first value of current and according to Ohm's Law.

In a next step S6, a second measurement is performed comprising the sub-steps S7 and S8. In this regard, the power supplied to the heating system 138 is changed to a much higher or lower value of voltage/current. During the sub-steps S7 and S8 a second value of a voltage and a second value of a current are measured.

In a next step S9, a second resistance value based on the measured second value of voltage and second value of current is calculated according to Ohm's Law.

In a next step S10, the first resistance value and the second resistance value are compared in order to determine a condition of the wind turbine blade 110.

In step S10 a difference is calculated between the first resistance value and the second resistance value and compared to a predefined threshold value, e.g. evaluated by an automatic controller unit. If there is no or only little difference in the resistance values it can be assumed that the condition of the heating system 138, and thus the wind turbine rotor blade 110, may be good or sufficiently good. Such evaluation more or less can be compared to the linear dependency as exemplarily shown in the first graph 134 in Figure 3. However, if the difference in resistance values is high, at least higher than a threshold value, this shows that the wind turbine rotor blade 110, at least the heating system 138, has suffered degradation, which can be compared to the exemplarily second graph 136 in Figure 3. In other words, at lower values of voltage and current the resistance value is high, compared to a resistance value at a higher value of voltage/current.

Thus, based on this evaluation, the health of the heating system 138 and further of the rotor blade 110 itself can be monitored and controlled in an easy and very inexpensive way.

In other words, according to the embodiment of the invention the measured differences in the resistance values are used for determining a condition of degradation of the heating system 138 or generally spoken of a conductive device of the wind turbine rotor blade 110. The embodiment of the invention does not aim to simply compare resistance values over time, but also to take into account different values of current/voltage at nearly the same measurement time.

Figure 7 shows this correlation in an exemplary way, wherein the curves 154, 155 and 156 shows the resistance R for a given current/voltage depending on the time t. The curve 154 represents the resistance according to the first measurement. The undamaged system has a resistance R0. With the time, the resistance increase, e.g. to R1 and R3 at respectively the time t1 and t2. A second measurement is executed with a lower value of current/voltage (curve 155) or a higher value of current/voltage (curve 156). The differences D1 and D2 between respective resistance values R1, R2 and R3, R4 are indicated after having performed the above described method at two times t1, t2. The same applies to the differences D1' and D2' accordingly.

We want to note that in the described embodiment the first and second measurements according to steps S2 and S6 are executed immediately after one another. Alternatively, these measurements are done for example within a time range as defined above. In particular, the time range is selected such that for at least the two measurements the environmental conditions are more or less the same and have not changed significantly.

One or more additional steps can be performed, as indicated above:

- For example, the second step can be repeated for different voltages/currents.
- For example, the above method can be repeated at regular intervals.
- For example, in a further step a service center, which is located remotely from the wind turbine, is provided with information, based on the determined condition.
- For example, depending on the determined condition of the wind turbine rotor blade 110, the wind turbine 100 or the wind turbine rotor blade 110 are adjusted.

Alternatively or additionally, the steps of performing the first and second measurements are performed on one of the heating elements 144 or a group of heating elements 144, in order that a specific heating element or a specific group could be evaluated. This, of course, requires the electric measurement system 146 to be adapted accordingly.

For performing the method, the wind turbine 100 and or the respective wind turbine rotor blade 110 may comprise a date processing device having a processor and a memory, the memory storing program code for performing the described method, wherein the program code is executed by the processor.

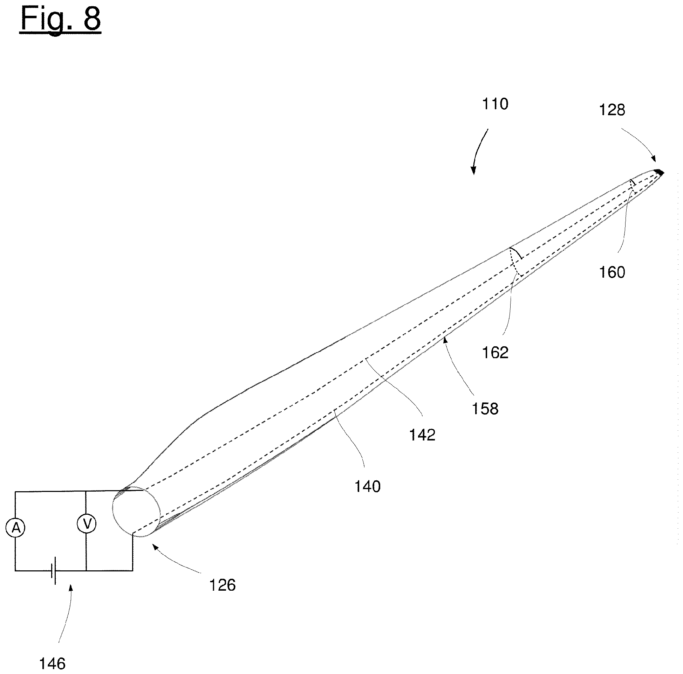

The described method is also applicable to other electrically conductive devices of a wind turbine rotor blade, e.g. a lightning protection system 158 as shown in Figure 8. The lightning protection system 158 also comprises two main conductors 140 and 142 which extend from the root end 126 to the tip 128. In order to monitor and control these main conductors 140 and 142 of the lightning protection system 158, it is necessary to interconnect the main conductors 140, 142, in particular in the area of the tip end 128. For example, the interconnection is a conductor element 160 with or without a resistor. It is also possible to provide a second interconnecting conductor element 162, with or without a resistor.

Thus, by connecting an electric measurement system 146 similar to the example according to Figures 4 and 5 at the root end 126, the method according to Figure 6 can be performed.

List of reference signs

| 100 | wind turbine |
| 102 | tower |
| 104 | foundation |
| 106 | nacelle |
| 108 | rotor |
| 110 | wind turbine blade |
| 112 | rotor hub |
| 114 | rotor blade root area |

116 transition area
118 profile area
120 longitudinal axis
122 pressure side
124 suction side
126 blade root end
128 blade tip end
130 profile nose edge
132 profile end edge
134 first graph
136 second graph
138 heating system
140 first main conductor
142 second main conductor
144 resistive heating element
146 electric measuring system
148 energy source
150 voltage measuring device
152 current measuring device
154 third graph
156 fourth graph
158 lightning protection system
160 first conductor element
162 second conductor element
D difference
I current
R resistance
t time
V voltage

**Claims**

1. A method of monitoring and controlling a condition of a wind turbine rotor blade (110), the method comprising the steps of:

   - performing a first measurement comprising the sub-steps (S3, S4) of:

      - measuring a first value of voltage applied to a conductive device of the wind turbine rotor blade (110); and
      - measuring a first value of current flowing through the conductive device, the first value of current corresponding to the first value of voltage;

   - calculating a first resistance value of the conductive device depending on the measured first value of voltage and the measured first value of current;
   - performing a second measurement comprising the sub-steps (S7, S8) of:

      - measuring a second value of voltage applied to the conductive device, the second value of voltage being higher or lower than the first value of voltage;
      - measuring a second value of current flowing through the conductive device, the second value of current corresponding to the second value of voltage and the second value of current being different than the first value of current;

   - calculating a second resistance value of the conductive device depending on the measured second value of voltage and the measured second value of current; and
   - comparing the first resistance value and the second resistance value in order to determine the condition of the wind turbine rotor blade (110).

2. The method according to claim 1, wherein the step (S10) of comparing comprises determining a difference between the first resistance value and the second resistance value, wherein based on the determined difference the condition of the wind turbine rotor blade (110) is determined.

3. The method according to claim 2, wherein the determined difference between the first and second resistance values corresponds to a failure or a degradation of the wind turbine rotor blade (110), in particular an electrical or mechanical degradation or an electrical or mechanical failure.

4. The method according to claim 3, wherein the determined difference is compared to a threshold value of resistance.

5. The method according to any one of claims 1 to 4, wherein, based on the determined condition, a service center, which is located remotely from a wind turbine (100), is provided with information.

6. The method according to any one of claims 1 to 5, wherein the conductive device is a lightning protection system (158) comprising two electrical main conductors (140, 142), the two electrical main conductors (140, 142) essentially extending from a root area of the wind turbine rotor blade (110) towards a tip area of the wind turbine rotor blade (110) and the two electrical main conductors (140, 142) being electrically interconnected.

7. The method according to claim 6, wherein the two electrical main conductors (140, 142) are interconnected in the tip area of the wind turbine rotor blade (110).

8. The method according to any one of claims 1 to 5, wherein the electrically conductive device is a heating system (138), the heating system (138) comprising two electrical main conductors (140, 142) and at least one resistive heating element (144), the two main conductors (140, 142) essentially extending from a root area of the wind turbine rotor blade (110) towards a tip area of the wind turbine rotor blade (110) and the at least one heating element (144) being electrically connected to both of the two main conductors (140, 142) in order to be supplied with heating current.

9. The method according to claim 8, wherein the heating system (138) comprises several resistive heating elements (144), each heating element (144) being electrically connected to both of the two main conductors (140, 142) in order to be supplied with electrical current, wherein the steps (S2, S6) of performing the first and second measurement are performed on one of the heating elements (144) or a group of heating elements (144).

10. The method according to any one of claims 1 to 9, wherein the step (S2) of performing the first measurement and the step (S6) of performing the second measurement is done within a time range of 1 hour, preferably of 30 minutes, 10 minutes, 5 minutes or less.

11. The method according to claim 10, wherein the steps (S2, S6) of performing the first measurement and performing the second measurement are executed immediately after one another.

12. The method according to any one of claims 1 to 11, wherein the method is repeated at regular intervals.

13. The method according to any one of claims 1 to 12, wherein, depending on the determined condition of the wind turbine rotor blade (110), the wind turbine (110) or the wind turbine rotor blade (110) are adjusted.

14. A wind turbine (110), comprising

  - a rotor (108) with one or more wind turbine rotor blades (110), and
  - a data processing device having a processor and a memory, the memory storing program code for performing a method according to any one of claims 1 to 13, wherein the program code is executed by the processor.

15. A computer readable storage medium having stored thereon instructions of a method according to any one of claims 1 to 13 to be executed by a processor.

**Patentansprüche**

1. Verfahren zum Überwachen und Steuern eines Zustands eines Windenergieanlagenrotorblatts (110), wobei das Verfahren die folgenden Schritte umfasst:

  - Durchführen einer ersten Messung mit den Unterschritten (S3, S4):

    - Messen eines ersten Werts einer Spannung, die an eine leitende Vorrichtung des Windenergieanlagenrotorblatts (110) angelegt wird; und
    - Messen eines ersten Wertes eines Stroms, der durch die leitende Vorrichtung fließt, wobei der erste Wert des Stroms dem ersten Wert der Spannung entspricht;

  - Berechnen eines ersten Werts eines Widerstands der leitfähigen Vorrichtung in Abhängigkeit von dem gemessenen ersten Wert der Spannung und dem gemessenen ersten Wert des Stroms;
  - Durchführen einer zweiten Messung mit den folgenden Teilschritten (S7, S8):

    - Messen eines zweiten Werts der an die leitende Vorrichtung angelegten Spannung, wobei der zweite Wert der Spannung höher/niedriger ist als der erste Wert der Spannung;
    - Messen eines zweiten Werts des Stroms, der durch die leitende Vorrichtung fließt, wobei der zweite Wert des Stroms dem zweiten Wert der Spannung entspricht und der zweite Wert des Stroms sich von dem ersten Wert des Stroms unterscheidet;

  - Berechnen eines zweiten Werts des Widerstands der leitfähigen Vorrichtung in Abhängigkeit von dem gemessenen zweiten Wert der Spannung und dem gemessenen zweiten Wert des Stroms; und
  - Vergleichen des ersten Werts des Widerstands und des zweiten Werts des Widerstands, um den Zustand des Windenergieanlagenrotorblatts (110) zu bestimmen.

2. Verfahren nach Anspruch 1, wobei der Schritt (S10) des Vergleichens das Bestimmen einer Differenz zwischen dem ersten Wert des Widerstands und dem zweiten Wert des Widerstands umfasst, wobei basierend auf der bestimmten Differenz der Zustand des Windenergieanlagenrotorblatts (110) bestimmt wird.

3. Verfahren nach Anspruch 2, wobei die ermittelte Differenz zwischen dem ersten und dem zweiten Wert des Widerstands einem Ausfall oder einer Verschlechterung des Windenergieanlagenrotorblatts entspricht, insbesondere einer elektrischen oder mechanischen Verschlechterung oder einem elektrischen oder mechanischen Ausfall.

4. Verfahren nach Anspruch 3, wobei die ermittelte Differenz mit einem Schwellenwert des Widerstands verglichen wird.

5. Verfahren nach einem der Ansprüche 1 bis 4, wobei, basierend auf dem ermittelten Zustand eine Servicezentrale, die sich entfernt von einer Windenergieanlage (100) befindet, mit Informationen versorgt wird.

6. Verfahren nach einem der Ansprüche 1 bis 5, wobei die leitende Vorrichtung ein Blitzschutzsystem (158) ist, das zwei elektrische Hauptleiter (140, 142) umfasst, wobei sich die beiden elektrischen Hauptleiter (140, 142) im Wesentlichen von einem Wurzelbereich des Windenergieanlagenrotorblatts (110) zu einem Spitzenbereich des Windenergieanlagenrotorblatts (110) erstrecken und die beiden elektrischen Hauptleiter (140, 142) elektrisch miteinander verbunden sind.

7. Verfahren nach Anspruch 6, wobei die beiden elektrischen Hauptleiter (140, 142) im Spitzenbereich des Windenergieanlagenrotorblatts (110) miteinander verbunden sind.

8. Verfahren nach einem der Ansprüche 1 bis 5, wobei die elektrisch leitende Vorrichtung ein Heizsystem (138) ist, wobei das Heizsystem (138) zwei elektrische Hauptleiter (140, 142) und mindestens ein Widerstandsheizelement (144) umfasst, wobei sich die beiden Hauptleiter (140, 142) im Wesentlichen von einem Wurzelbereich des Windenergieanlagenrotorblatts (110) in Richtung eines Spitzenbereichs des Windenergieanlagenrotorblatts (110) erstrecken und das mindestens eine Heizelement (144) elektrisch mit beiden der zwei Hauptleiter (140, 142) verbunden ist, um mit Heizstrom versorgt zu werden.

9. Verfahren nach Anspruch 8, wobei das Heizsystem (138) mehrere Widerstandsheizelemente (144) umfasst, wobei jedes Heizelement (144) mit beiden Hauptleitern (140, 142) elektrisch verbunden ist, um mit elektrischem Strom versorgt zu werden, wobei die Schritte (S2, S6) der Durchführung der ersten und zweiten Messung an einem der Heizelemente (144) oder einer Gruppe von Heizelementen (144) durchgeführt werden.

10. Verfahren nach einem der Ansprüche 1 bis 9, wobei der Schritt (S2) der Durchführung der ersten Messung und der Schritt (S6) der Durchführung der zweiten Messung innerhalb eines Zeitbereichs von 1 Stunde, vorzugsweise von 30 Minuten, 10 Minuten, 5 Minuten oder weniger durchgeführt wird.

11. Verfahren nach Anspruch 10, wobei die Schritte (S2, S6) der Durchführung der ersten Messung und der Durchführung der zweiten Messung unmittelbar nacheinander ausgeführt werden.

12. Verfahren nach einem der Ansprüche 1 bis 11, wobei das Verfahren in regelmäßigen Abständen wiederholt wird.

13. Verfahren nach einem der Ansprüche 1 bis 12, wobei in Abhängigkeit von dem ermittelten Zustand des Windenergieanlagenrotorblatts (110) die Windenergieanlage (100) oder das Windenergieanlagenrotorblatt (110) eingestellt werden.

14. Windenergieanlage (100), umfassend

- einen Rotor (108) mit einem oder mehreren Windenergieanlagenrotorblättern (110), und
- eine Datenverarbeitungsvorrichtung mit einem Prozessor und einem Speicher, wobei der Speicher einen Programmcode zur Durchführung eines Verfahrens nach einem der Ansprüche 1 bis 13 speichert, wobei der Programmcode von dem Prozessor ausgeführt wird.

15. Computerlesbares Speichermedium mit darauf gespeicherten Anweisungen für ein Verfahren nach einem der Ansprüche 1 bis 13 zur Ausführung durch einen Prozessor.

**Revendications**

1. Procédé de surveillance et de commande d'un état d'une pale de rotor d'éolienne (110), le procédé comprenant les étapes de :

- exécution d'une première mesure comprenant les sous-étapes (S3, S4) de :

o mesure d'une première valeur de tension appliquée à un appareil conducteur de la pale de rotor d'éolienne (110) ; et
o mesure d'une première valeur de courant passant à travers l'appareil conducteur, la première valeur de courant correspondant à la première valeur de tension ;

- calcul d'une première valeur de résistance de l'appareil conducteur en fonction de la première valeur de tension mesurée et de la première valeur de courant mesurée ;
- exécution d'une deuxième mesure comprenant les sous-étapes (S7, S8) de :

  o mesure d'une deuxième valeur de tension appliquée à l'appareil conducteur, la deuxième valeur de tension étant supérieure ou inférieure à la première valeur de tension ;

  o mesure d'une deuxième valeur de courant passant à travers l'appareil conducteur, la deuxième valeur de courant correspondant à la deuxième valeur de tension et la deuxième valeur de courant étant différente de la première valeur de courant ;

- calcul d'une deuxième valeur de résistance de l'appareil conducteur en fonction de la deuxième valeur de tension mesurée et de la deuxième valeur de courant mesurée ; et

- comparaison de la première valeur de résistance et de la deuxième valeur de résistance afin de déterminer l'état de la pale de rotor d'éolienne (110).

2. Le procédé selon la revendication 1, sachant que l'étape (S10) de comparaison comprend la détermination d'une différence entre la première valeur de résistance et la deuxième valeur de résistance, sachant que sur la base de la différence déterminée, l'état de la pale de rotor d'éolienne (110) est déterminé.

3. Le procédé selon la revendication 2, sachant que la différence déterminée entre la première et la deuxième valeur de résistance correspond à une défaillance ou une dégradation de la pale de rotor d'éolienne (110), en particulier une dégradation électrique ou mécanique ou une défaillance électrique ou mécanique.

4. Le procédé selon la revendication 3, sachant que la différence déterminée est comparée à une valeur de résistance seuil.

5. Le procédé selon l'une quelconque des revendications 1 à 4, sachant que, sur la base de l'état déterminé, un centre d'entretien, qui est situé de manière déportée par rapport à une éolienne (100), est doté d'informations.

6. Le procédé selon l'une quelconque des revendications 1 à 5, sachant que l'appareil conducteur est un système de protection contre la foudre (158) comprenant deux conducteurs électriques principaux (140, 142), les deux conducteurs électriques principaux (140, 142) s'étendant sensiblement depuis une zone de racine de la pale de rotor d'éolienne (110) vers une zone de pointe de la pale de rotor d'éolienne (110) et les deux conducteurs électriques principaux (140, 142) étant interconnectés électriquement.

7. Le procédé selon la revendication 6, sachant que les deux conducteurs électriques principaux (140, 142) sont interconnectés dans la zone de pointe de la pale de rotor d'éolienne (110).

8. Le procédé selon l'une quelconque des revendications 1 à 5, sachant que l'appareil électriquement conducteur est un système de chauffage (138), le système de chauffage (138) comprenant deux conducteurs électriques principaux (140, 142) et au moins un élément chauffant (144) résistif, les deux conducteurs principaux (140, 142) s'étendant sensiblement depuis une zone de racine de la pale de rotor d'éolienne (110) vers une zone de pointe de la pale de rotor d'éolienne (110) et l'au moins un élément chauffant (144) étant connecté électriquement à l'un et l'autre des deux conducteurs principaux (140, 142) afin d'être alimenté en courant de chauffage.

9. Le procédé selon la revendication 8, sachant que le système de chauffage (138) comprend plusieurs éléments chauffants (144) résistifs, chaque élément chauffant (144) étant connecté électriquement à l'un et l'autre des deux conducteurs principaux (140, 142) afin d'être alimenté en courant électrique, sachant que les étapes (S2, S6) d'exécution de la première et de la deuxième mesure sont exécutées dans un des éléments chauffants (144) ou dans un groupe d'éléments chauffants (144).

10. Le procédé selon l'une quelconque des revendications 1 à 9, sachant que l'étape (S2) d'exécution de la première mesure et l'étape (S6) d'exécution de la deuxième mesure sont effectuées au sein d'une plage de temps de 1 heure, de préférence de 30 minutes, 10 minutes, 5 minutes ou moins.

11. Le procédé selon la revendication 10, sachant que les étapes (S2, S6) d'exécution de la première mesure et d'exécution de la deuxième mesure sont effectuées immédiatement l'une après l'autre.

12. Le procédé selon l'une quelconque des revendications 1 à 11, sachant que le procédé est répété à intervalles réguliers.

13. Le procédé selon l'une quelconque des revendications 1 à 12, sachant que, en fonction de l'état déterminé de la pale de rotor d'éolienne (110), l'éolienne (110) ou la pale de rotor d'éolienne (110) sont ajustées.

14. Éolienne (110), comprenant

- un rotor (108) comportant une ou plusieurs pales de rotor d'éolienne (110), et
- un appareil de traitement de données présen-

**EP 3 919 740 B1**

tant un processeur et une mémoire, la mémoire stockant un code de programme destiné à exécuter un procédé selon l'une quelconque des revendications 1 à 13, sachant que le code de programme est exécuté par le processeur.

15. Support de stockage lisible par ordinateur sur lequel sont stockées des instructions d'un procédé selon l'une quelconque des revendications 1 à 13 devant être exécuté par un processeur.

# Fig. 1

Fig. 2

Fig. 3

Fig. 4

Fig. 5

Fig. 6

Fig. 7

# Fig. 8

**EP 3 919 740 B1**

**Patent documents cited in the description**

- EP 3165761 A1
- EP 2843228 A1

- WO 2017167347 A1